# DEMANDE DE BREVET EUROPEEN

(11) **EP 3 696 907 A1**
(43) Date de publication de la demande: **19.08.2020**
(21) Numéro de dépôt: 20157332.6
(22) Date de dépôt: 14.02.2020
(51) Int. Cl.: H01P 1/20, H05K 1/02

(54) **LIGNE DE TRANSMISSION RADIOFRÉQUENCE, DISPOSITIF COMPORTANT UNE TELLE LIGNE DE TRANSMISSION ET SYSTÈME DE SURVEILLANCE D'UNE INSTALLATION COMPORTANT UN TEL DISPOSITIF**

(30) Priorité: 15.02.2019 FR 1901577
(71) Demandeur: Schneider Electric Industries SAS, 92500 Rueil Malmaison (FR)
(72) Inventeur: NIEMBRO, Alejandro, 38050 Grenoble Cedex 09 (FR); DREINA, Emmanuel, 38050 Grenoble Cedex 09 (FR)
(74) Mandataire: Lavoix

(57) **Abrégé**

L'invention concerne une ligne de transmission radiofréquence (90) configurée pour permettre la transmission d'un signal électrique radiofréquence entre une première extrémité (120) et une deuxième extrémité (125), la ligne de transmission (90) comportant un conducteur principal (135) et un plan de masse (140) électriquement connecté à une masse électrique de la ligne de transmission (90),

Le plan de masse (140) comporte un ensemble de portions (152, 157) reliées en série entre la première extrémité (120) et la deuxième extrémité (125) et un ensemble de deuxièmes condensateurs (163), l'ensemble de portions (152, 157) comportant un ensemble de deuxièmes portions (152), chaque deuxième condensateur (163) étant interposé entre deux deuxièmes portions (152) contigües.

## Description

La présente invention concerne une ligne de transmission radiofréquence. La présente invention concerne également un dispositif comportant une telle ligne de transmission radiofréquence, ainsi qu'un système de surveillance d'une installation comportant un tel dispositif.

De nombreux dispositifs comportent des modules de communication radiofréquence propres à échanger des données via des ondes électromagnétiques présentant des fréquences comprises entre 1 mégahertz (MHz) et 100 gigahertz (GHz). Ces dispositifs comportent en général des modules de contrôle propres à générer ou à recevoir un signal électrique radiofréquence, ainsi qu'une ou plusieurs antennes permettant la conversion de ces signaux électriques en ondes électromagnétiques et vice-versa.

De tels dispositifs sont utilisés dans un grand nombre d'applications, et peuvent être alimentés par un grand nombre de sources électriques différentes, notamment par simple branchement sur un réseau de distribution d'électricité présentant une tension élevée susceptible de présenter un risque pour l'être humain. La tension électrique délivrée par une source électrique externe au dispositif est en général adaptée via un circuit interne d'alimentation qui alimente alors le ou les modules de contrôle avec une tension, une intensité et, le cas échéant, une fréquence appropriée. Afin de protéger d'éventuels utilisateurs des risques électriques, le dispositif comporte en général un boîtier de protection et d'isolation électrique renfermant le circuit de transformation et le(s) module(s) de contrôle. Ces dispositifs sont généralement intégrés dans des coffrets électriques qui peuvent bloquer les ondes radio.

Dans certains cas, le boîtier forme un obstacle à la propagation des ondes électromagnétiques émises et/ou reçues par l'antenne. Dans d'autres cas, le dispositif est disposé dans une installation comportant une enceinte ou une enveloppe formant un tel obstacle, ou encore dans une installation installée dans un emplacement ne permettant pas à un signal radiofréquence de se propager directement jusqu'au dispositif destiné à recevoir ces informations, notamment dans le cas de coffrets métalliques. Dans ces cas, l'antenne est disposée à l'extérieur du boîtier du dispositif ou de l'enceinte de l'installation, voire déportée par rapport à l'installation jusqu'à un endroit propice à la propagation des ondes radiofréquence. Il est alors nécessaire de prévoir un connecteur traversant une paroi du boîtier ou de l'enceinte et reliant l'antenne au(x) module(s) de contrôle. Pour protéger les utilisateurs contre le risque d'électrisation, le circuit interne d'alimentation est prévu pour permettre une isolation, notamment une isolation galvanique, entre la source externe de courant et le module de contrôle. Ainsi, c'est au niveau du circuit d'alimentation interne que l'isolation a lieu, de sorte que tous les éléments situés en aval du circuit d'alimentation interne sont isolés de la source externe.

Cependant, les circuits internes d'alimentation permettant une isolation des éléments situés en aval par rapport aux éléments situés en amont sont en général volumineux et peu adaptables, puisqu'ils comportent des transformateurs dont les propriétés sont fixées par la géométrie et qui sont souvent conçus spécifiquement pour des applications précises.

Il existe donc un besoin pour un dispositif radiofréquence comportant une antenne et une alimentation, qui permette une bonne isolation de l'antenne tout en présentant de petites dimensions.

A cet effet, il est proposé une ligne de transmission radiofréquence présentant une première extrémité et une deuxième extrémité, la ligne de transmission étant configurée pour permettre la transmission d'un signal électrique radiofréquence entre la première extrémité et la deuxième extrémité, la ligne de transmission comportant un conducteur principal et un plan de masse électriquement connecté à une masse électrique de la ligne de transmission, le conducteur principal comportant un ensemble de portions reliées en série entre la première extrémité et la deuxième extrémité et un ensemble de premiers condensateurs, l'ensemble de portions comportant un ensemble de premières portions, chaque premier condensateur étant interposé entre deux premières portions contigües, chaque premier condensateur comportant une première électrode électriquement connectée à l'une des premières portions entre lesquelles le premier condensateur est interposé et une deuxième électrode électriquement connectée à l'autre des premières portions entre lesquelles le premier condensateur est interposé, le plan de masse comportant un ensemble de portions reliées en série entre la première extrémité et la deuxième extrémité et un ensemble de deuxièmes condensateurs, l'ensemble de portions comportant un ensemble de deuxièmes portions, chaque deuxième condensateur étant interposé entre deux deuxièmes portions contigües, chaque deuxième condensateur comportant une troisième électrode électriquement connectée à l'une des deuxièmes portions entre lesquelles le deuxième condensateur est interposé et une quatrième électrode électriquement connectée à l'autre des deuxièmes portions entre lesquelles le deuxième condensateur est interposé.

Grâce à l'invention, les deux extrémités de la ligne de transmission sont effectivement isolées l'une de l'autre, notamment pour les signaux électriques dont la fréquence est faible, par exemple inférieure ou égale à 10 kilohertz (kHz) tout en permettant la transmission d'un signal électrique radiofréquence entre ces deux extrémités. Un dispositif comprenant un circuit radiofréquence comportant cette ligne de transmission est alors susceptible de comporter une alimentation électrique non-isolée, les éléments du circuit radiofréquence qui sont situés à l'extérieur du boîtier étant alors isolés par la ligne de transmission du reste du circuit, de sorte que ces éléments peuvent être touchés sans risque par un opérateur même si une partie du circuit est alimentée avec une tension dangereuse pour l'être humain. Il est alors possible d'utiliser pour cette partie non-isolée du circuit des composants, et notamment une alimentation électrique, de plus petites dimensions que les composants utilisés dans l'état de la technique.

Selon des modes de réalisation particuliers, la ligne de transmission radiofréquence comporte l'une ou plusieurs des caractéristiques suivantes, prises isolément ou selon toutes les combinaisons techniquement possibles :
- chaque premier condensateur est configuré pour empêcher le passage d'un courant électrique entre la première électrode et la deuxième électrode en cas de défaut électrique du premier condensateur et chaque deuxième condensateur est configuré pour empêcher le passage d'un courant électrique entre la troisième électrode et la quatrième électrode en cas de défaut électrique du deuxième condensateur ;
- chaque premier condensateur et chaque deuxième condensateur présente une capacité supérieure ou égale à 10 picofarads, notamment comprise entre 10 picofarads et 4,7 nanofarads ;
- le conducteur principal comprend, en outre, au moins deux troisièmes portions et au moins un troisième condensateur présentant une capacité inférieure ou égale à 50 picofarads, le troisième condensateur étant interposé entre les deux troisièmes portions et comportant une cinquième électrode électriquement connectée à l'une des troisièmes portions et une sixième électrode électriquement connectée à l'autre troisième portion ;
- la ligne de transmission comporte en outre au moins un circuit écrêteur de tension configuré pour limiter, en valeur absolue, une différence de potentiel électrique entre le conducteur principal et le plan de masse ;
- chaque circuit écrêteur de tension comporte une première borne de connexion électriquement connectée à une deuxième portion du conducteur principal et une deuxième borne de connexion électriquement connectée au plan de masse ;
- la ligne de transmission comporte un substrat présentant deux faces de support parallèles l'une à l'autre, chaque premier condensateur du conducteur principal étant porté par l'une des faces de support, chaque deuxième condensateur du plan de masse étant porté par l'autre face de support, chaque face de support étant perpendiculaire à une direction normale du substrat, chaque premier condensateur du conducteur principal étant aligné selon la direction normale avec un deuxième condensateur correspondant du plan de masse.

Il est également proposé un dispositif radiofréquence comprenant une ligne de transmission radiofréquence telle que précédemment décrite.

Selon un mode de réalisation particulier, le dispositif radiofréquence comporte un module de contrôle, une antenne reliée au module de contrôle via la ligne de transmission radiofréquence et une alimentation propre à recevoir une première tension électrique et à convertir la première tension électrique en une deuxième tension électrique d'alimentation du module de contrôle, la première tension électrique étant notamment supérieure ou égale à 24 volts.

Il est également proposé un système de surveillance d'une installation comportant une enceinte, le système comportant un dispositif radiofréquence et un dispositif de centralisation, l'antenne étant disposée à l'extérieur de l'enceinte, le module de contrôle étant accueilli à l'intérieur de l'enceinte, la ligne de transmission étant configurée pour transmettre des signaux électriques radiofréquence entre le module de contrôle et l'antenne, le module de contrôle étant configuré pour communiquer avec le dispositif de centralisation par communication radiofréquence via l'antenne.

Des caractéristiques et avantages de l'invention apparaîtront à la lecture de la description qui va suivre, donnée uniquement à titre d'exemple non limitatif, et faite en référence aux dessins annexés, sur lesquels :
[Fig 1] la figure 1 est une représentation schématique d'une installation comportant un dispositif radiofréquence comprenant une ligne de transmission radiofréquence,
[Fig 2] la figure 2 est une représentation schématique partielle en coupe de la ligne de transmission de la figure 1,
[Fig 3] la figure 3 est un schéma électrique partiel de la ligne de transmission de la figure 2, et
[Fig 4] la figure 4 est une représentation schématique d'un mode de réalisation spécifique de l'installation de la figure 1.

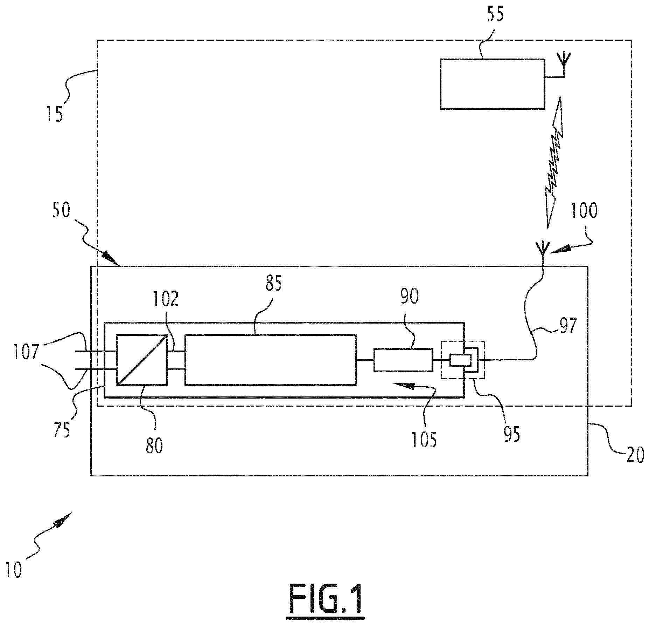

Une installation 10 et un système de contrôle 15 de l'installation sont représentés partiellement sur la figure 1.

L'installation 10 est, par exemple, une installation électrique comportant un ensemble de conducteurs électriques et, optionnellement, un ou plusieurs organes fonctionnels. Par exemple, l'installation 10 est une armoire électrique, un poteau de luminaire, un mat d'une éolienne, ou encore un poste de transformation. Toutefois, d'autres types d'installations électriques 10 sont susceptibles d'être envisagés.

Chaque organe fonctionnel est, par exemple, un dispositif alimenté par les conducteurs, ou encore un dispositif propre à modifier un courant ou une tension électrique des conducteurs tel qu'un interrupteur ou un transformateur.

L'installation 10 comporte une enceinte 20.

L'enceinte 20 délimite un volume intérieur Vi de l'enceinte.

L'enceinte 20 est propre à isoler le volume intérieur Vi de l'enceinte de l'extérieur de l'enceinte 20. Cela signifie notamment que l'enceinte 20 est propre à empêcher à une personne non-autorisée d'accéder au volume intérieur Vi. Cela signifie également que l'enceinte 20 est configurée pour empêcher la circulation d'un courant électrique depuis le volume intérieur Vi jusqu'à l'extérieur de l'enceinte 20, et vice-versa.

Par exemple, l'enceinte 20 comporte quatre murs de béton et un toit. En variante, l'enceinte 20 est réalisée au moins partiellement, par exemple complètement, en un matériau métallique.

L'enceinte 20 est, par exemple, reliée électriquement à la terre.

Le système de contrôle 15 comporte un dispositif radiofréquence 50 et un dispositif de centralisation 55.

Il est notamment entendu par « système de contrôle » que le système de contrôle 15 est configuré pour permettre un échange de données relatives à l'installation 10 entre l'installation 10 et un emplacement distant de l'installation 10.

Selon un mode de réalisation, le système de contrôle 15 est configuré pour transmettre des données depuis l'installation 10 jusqu'à l'emplacement distant ou vice-versa.

Les données que le système de contrôle 15 est configuré pour transmettre sont susceptibles d'être de toute nature. Par exemple, les données comprennent une commande à destination d'un organe fonctionnel de l'installation 10, une valeur ou un ensemble de valeurs de paramètres de l'installation 10, ou encore le résultat d'un calcul effectué par un organe fonctionnel de l'installation 10.

Le dispositif radiofréquence 50 est configuré pour générer et/ou recevoir et/ou traiter des données sous la forme de signaux électriques ou d'ondes électromagnétiques radiofréquence. En particulier, le dispositif radiofréquence 50 est configuré pour échanger des données avec le dispositif de centralisation 55 sous forme d'ondes électromagnétiques radiofréquence. Le dispositif radiofréquence 50 est susceptible, en outre, de remplir un grand nombre de fonctions additionnelles.

Le dispositif radiofréquence 50 est, par exemple, prévu pour jouer le rôle de passerelle ou de concentrateur entre un ou plusieurs dispositifs reçus dans le volume intérieur Vi de l'enceinte 20 et le dispositif de centralisation 55. En particulier, le dispositif radiofréquence 50 est prévu pour recevoir des données du ou des dispositifs reçus dans le volume intérieur Vi de l'enceinte 20 et pour transmettre ces données au dispositif de centralisation 55, ou encore pour recevoir des données du dispositif de centralisation 55 et pour transmettre ces données au(x) dispositif(s) reçu(s) dans le volume intérieur Vi de l'enceinte 20.

Selon une autre variante, le dispositif radiofréquence 50 est lui-même configuré pour générer des données et pour transmettre ces données au dispositif de centralisation 55. Par exemple, le dispositif radiofréquence 50 comprend au moins un capteur configuré pour mesurer des valeurs de paramètres de l'installation 10, et pour transmettre les valeurs mesurées au dispositif de centralisation 55.

Selon encore une variante, le dispositif radiofréquence 50 est configuré pour recevoir du dispositif de centralisation 55, par communication radiofréquence, un message de modification d'un état d'un organe fonctionnel de l'installation 10, par exemple un message de commutation de l'organe fonctionnel entre deux états.

Selon une variante additionnelle, le dispositif radiofréquence 50 comprend au moins un organe fonctionnel propre à modifier un paramètre de l'installation 10, par exemple à commuter entre une position permettant le passage d'un courant électrique entre deux conducteurs et une position empêchant le passage de courant entre ces conducteurs. En particulier, le dispositif 50 est un relais.

Le dispositif radiofréquence 50 comporte un boîtier 75, une alimentation électrique 80, un module de contrôle 85, une ligne de transmission radiofréquence 90, un connecteur 95, un câble de transmission 97 optionnel et une première antenne 100.

Le boîtier 75 délimite une chambre 105 accueillant l'alimentation électrique 80, le module de contrôle 85 et la ligne de transmission 90.

Le boîtier 75 est configuré pour isoler électriquement l'intérieur de la chambre 105 de l'extérieur du boîtier 75.

Le boîtier 75 est réalisé en un matériau électriquement isolant. Par exemple, le boîtier 75 est réalisé en matière plastique.

Le boîtier 75 est accueilli dans le volume intérieur Vi de l'enceinte 20.

L'alimentation électrique 80 est, par exemple, propre à recevoir un premier courant électrique présentant une tension électrique U1. La tension électrique U1 est, par exemple, une tension continue ou alternative présentant un risque pour les personnes, par exemple une valeur de tension supérieure ou égale à 24V volts (V).

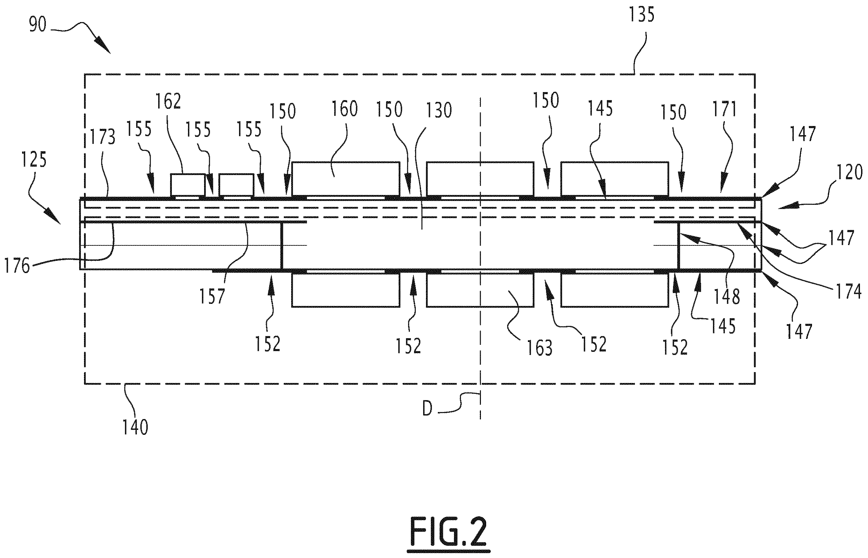

Selon l'exemple représenté sur la figure 2, l'alimentation 80 est propre à recevoir le premier courant électrique via des conducteurs d'entrée 107 traversant une paroi du boîtier 75.

L'alimentation électrique 80 est configurée pour alimenter électriquement le module de contrôle 85 avec un deuxième courant électrique. L'alimentation électrique 80 est, notamment, électriquement connectée au module de contrôle 85 par des conducteurs électriques de sortie 102.

Le deuxième courant électrique présente une tension électrique U2. La tension électrique délivrée par l'alimentation électrique 80 est, par exemple, une tension continue.

La tension électrique U2 est strictement inférieure à la tension électrique U1 reçue par l'alimentation électrique 80. Par exemple, la tension électrique U2 présente une valeur de tension inférieure ou égale à 12 V, notamment égale à 12V, ou encore égale à 5 V.

L'alimentation électrique 80 est donc propre à convertir la tension électrique U1 en la tension électrique U2.

L'alimentation électrique 80 est, selon un mode de réalisation, une alimentation non isolée. En particulier, au moins un des conducteurs de sortie 102 est électriquement connecté à l'un des conducteurs d'entrée 107. Selon un mode de réalisation, un conducteur de sortie 102 jouant le rôle de neutre pour le deuxième courant est électriquement connecté à un conducteur d'entrée 107 jouant ce même rôle pour le premier courant.

Le module de contrôle 85 est configuré pour traiter des données sous forme de signaux électriques.

Par exemple, le module de contrôle 85 est configuré pour générer un message radiofréquence propre à être émis via la première antenne 100 à destination du dispositif de centralisation 55. En particulier, le module de contrôle 85 est configuré pour recevoir des données et pour générer le message radiofréquence à partir des données reçues.

Les données à partir desquelles le message radiofréquence est généré sont susceptibles d'être de toute nature.

Selon une variante, le module de contrôle 85 est configuré pour recevoir un message radiofréquence depuis le dispositif de centralisation 55 via la première antenne 100, et pour extraire des données du message radiofréquence, ces données pouvant être de toute nature.

Par exemple, le module de contrôle 85 est configuré pour extraire du message radiofréquence une commande à destination d'un organe fonctionnel externe au module de contrôle 85 et pour transmettre la commande à cet organe fonctionnel.

Le message radiofréquence que le module de contrôle 85 est configuré pour émettre et/ou recevoir comprend un signal électrique radiofréquence.

La ligne de transmission 90 est configurée pour transmettre des signaux électriques radiofréquence entre le module de contrôle 85 et le connecteur 90.

Il est notamment entendu par « signal électrique radiofréquence » un signal électrique variable présentant au moins une fréquence comprise entre 1 MHz et 10GHz. Un signal électrique présentant une intensité variant avec une fréquence comprise entre 1 MHz et 10GHz est un exemple de signal électrique radiofréquence. Un signal électrique présentant une tension variant avec une fréquence comprise entre 1 MHz et 10GHz est un autre exemple de signal électrique radiofréquence.

La ligne de transmission 90 est représentée en coupe sur la figure 2.

La ligne de transmission 90 présente une première extrémité 120 et une deuxième extrémité 125. La ligne de transmission 90 est configurée pour transmettre le signal électrique radiofréquence entre la première extrémité 120 et la deuxième extrémité 125, et vice-versa.

La première extrémité 120 est, par exemple connectée au connecteur 95 alors que la deuxième extrémité 125 est connectée au module de contrôle 85.

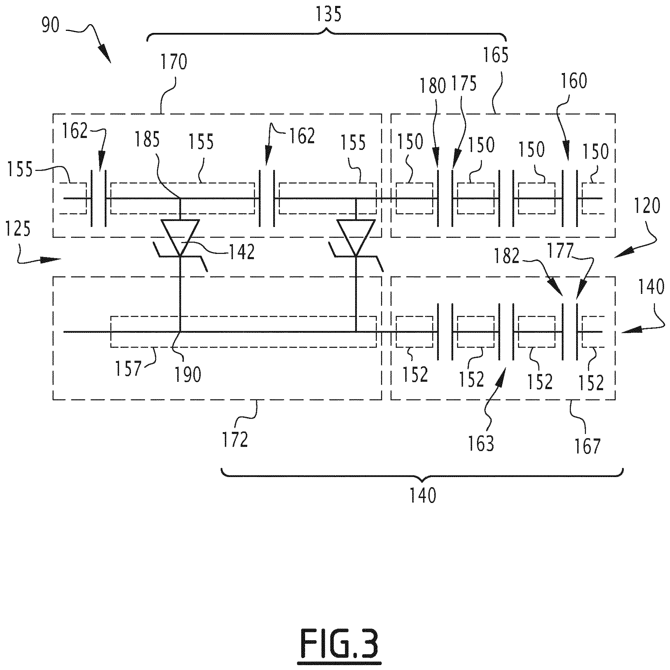

La ligne de transmission 90 comporte un substrat 130, un conducteur principal 135, et un plan de masse 140. Selon un mode de réalisation particulier, la ligne de transmission 90 comporte, en outre, au moins un circuit écrêteur de tension 142, qui est représenté sur la figure 3.

Le substrat 130 présente deux faces de support 145. Chaque face de support 145 est, par exemple, plane.

Le substrat 130 est réalisé en un matériau électriquement isolant, par exemple en une matière plastique, ou encore en un matériau composite tel qu'une résine comportant des fibres de renfort, notamment des fibres de verre.

Le substrat 130 est, notamment, une carte de circuit imprimé sur laquelle le conducteur 135 et le plan de masse 140 sont au moins partiellement formés par une couche d'un matériau métallique tel que du cuivre portée par certaines portions des faces de support 145.

Les faces de support 145 sont, par exemple, parallèles l'une à l'autre.

Selon un mode de réalisation, il est défini pour le substrat 130 plusieurs niveaux 147 de couches superposées selon la direction normale D.

Le substrat 130 est, par exemple, obtenu par collage de plaques portant chacune sur au moins une de leurs faces une couche d'un matériau métallique. Les couches sont formées pour définir des portions conductrices, par exemple en retirant localement le matériau métallique pour ne laisser subsister que les portions conductrices désirées.

Les portions conductrices appartenant à des niveaux de couches 147 distincts sont reliés les unes aux autres par des vias conductrices 148 reliant des niveaux de couches et s'étendant selon la direction normale D.

Selon l'exemple représenté sur la figure 3, le support 130 comporte quatre niveaux 147 de couches, toutefois le nombre de niveaux est susceptible de varier. En particulier, deux des niveaux 147, appelés « couches externes » sont portés par les faces de support 145, les deux autres niveaux, appelés « couches internes » étant enfouis dans le support 130. Selon une variante envisageable, le support 130 comporte uniquement deux niveaux 147 de couches portées par les faces de support 145.

Il est défini une direction normale D pour le substrat 130. Chaque face de support 145 est, par exemple, perpendiculaire à la direction normale D. Par exemple, une distance, selon la direction normale D, entre deux niveaux 147 successifs, est constante pour toute paire de deux niveaux 147 successifs.

Le conducteur principal 135 et le plan de masse 140 sont en regard l'un de l'autre. En particulier, le conducteur principal 135 et le plan de masse 140 sont alignés selon la direction principale D.

Le conducteur principal 135 est porté par le substrat 130. Par exemple, le conducteur principal 135 est porté par une face de support 145 du substrat 130.

Le conducteur principal 135 comporte une première partie 165 et, optionnellement, une deuxième partie 170. La première partie 165 est, par exemple, délimitée par la première extrémité 120 et par la deuxième partie 170, la deuxième partie 170 étant alors délimitée par la deuxième extrémité 125 et par la première partie 165. Toutefois, des variantes selon lesquelles la première partie 165 est délimitée par la deuxième extrémité 125 et par la deuxième partie 170, la deuxième partie 170 étant alors délimitée par la première extrémité 120 et par la première partie 165, sont également envisageables.

Dans une variante où aucune deuxième partie 170 ne serait présente, la première partie 165 est alors délimitée par la première extrémité 120 et par la deuxième extrémité 125.

La première partie 165 comporte un ensemble de premières portions 150, un ensemble de premiers condensateurs 160 et une première portion d'extrémité 171. La première partie 165 est propre à transmettre le signal électrique entre la première extrémité 120 et la deuxième partie 170.

La deuxième partie 170 comporte un ensemble de deuxièmes portions 155, un ensemble de deuxièmes condensateurs 162 et une deuxième portion d'extrémité 173.

Chaque première ou deuxième portion 150, 155 ainsi que chaque première ou deuxième portion d'extrémité 171, 173 est, par exemple, réalisée sous la forme d'un film conducteur porté par le substrat 130. En particulier, chaque portion 150, 155, 171, 173 est réalisée en un matériau métallique tel que le cuivre.

Chaque première ou deuxième portion 150, 155 ainsi que chaque première ou deuxième portion d'extrémité 171, 173 est, notamment, une portion d'un niveau de couche métallique 147 porté par une des faces de support 145.

Les premières portions 150 du conducteur principal 135 sont reliées en série. En particulier, aucune deuxième portion 155 n'est interposée entre deux premières portions 150 et aucune première portion 150 n'est interposée entre deux deuxièmes portions 155.

L'une des premières portions 150 est électriquement connectée à la première portion d'extrémité 171, une autre première portion 150 étant électriquement connectée à l'une des deuxièmes portions 155, les autres premières portions 150 étant reliées en série entre la première portion 150 électriquement connectée à la première portion d'extrémité 171 et la première portion 150 électriquement connectée à l'une des deuxièmes portions 155.

La première portion 150 électriquement connectée à la première portion d'extrémité 171 est, notamment, venue de matière avec cette première portion d'extrémité 171. La première portion 150 électriquement connectée à l'une des deuxièmes portions 155 est, notamment, venue de matière avec cette deuxième portion 155.

Il est défini une largeur pour chaque portion 150, 155, 171, 173. La largeur est mesurée dans un plan perpendiculaire à la direction normale D, selon une direction perpendiculaire à la direction dans laquelle le signal électrique se propage dans la première portion 150.

Selon un mode de réalisation, les premières portions 150 sont alignées selon une direction principale DP, comme représenté sur la figure 3. La direction principale DP est perpendiculaire à la direction normale D.

Chaque première portion 150 est, par exemple, rectangulaire, chaque côté du rectangle étant soit perpendiculaire soit parallèle à la direction principale DP. Dans ce cas, la largeur est mesurée entre les deux côtés parallèles à la direction principale DP. Il est à noter que la forme de chaque première portion 150 est susceptible de varier.

La largeur de chaque première portion 150 dépend de l'impédance de ligne, de l'épaisseur et la permittivité du substrat ; elle est, par exemple, comprise entre 0,1 millimètre (mm) et 10 mm. Toutefois, la largeur de chaque première portion 150 est susceptible de varier.

La première portion d'extrémité 171 relie la première portion 150 correspondante à la première extrémité 120. Par exemple, la première portion d'extrémité 171 est électriquement connectée au connecteur 95.

La première portion d'extrémité 171 présente, par exemple, une largeur strictement inférieure à la largeur des premières portions 150. En particulier, la largeur de la première portion d'extrémité 171 est égale à un tiers de la largeur des premières portions 150. Cependant, la largeur de la première portion d'extrémité 171 est susceptible de varier.

Un premier condensateur 160 est interposé entre chaque paire de premières portions 150 contigües. Par exemple, chaque premier condensateur 160 comporte une première électrode 175 et une deuxième électrode 180, la première électrode 175 étant électriquement connectée à une première portion 150 et la deuxième électrode 180 étant connectée à une autre première portion 150, cette autre première portion 150 étant notamment elle-même connectée à la première électrode 175 d'un autre premier condensateur 160 dont la deuxième électrode 180 est connectée à encore une autre première portion 150. Ainsi, les premières portions 150 de chaque paire de premières portions 150 contigües sont reliées en série par un premier condensateur 160 interposé entre les deux premières portions 150 considérées.

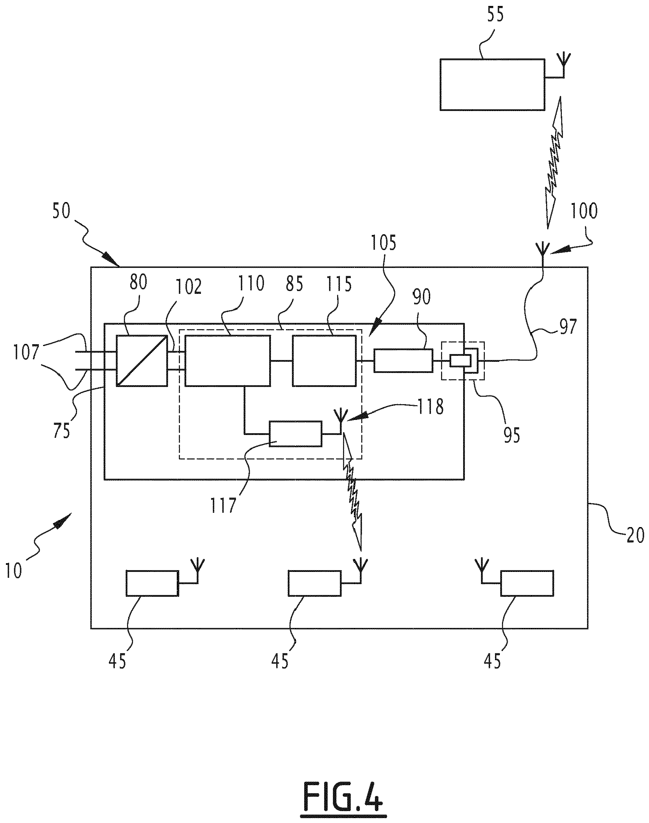

Selon l'exemple représenté sur les figures 3 et 4, le conducteur principal 135 comporte quatre premières portions 150 et trois premiers condensateurs 160. Toutefois, il est à noter que le nombre de premières portions 150 et de premiers condensateurs 160 est susceptible de varier.

Les deuxièmes portions 155 sont, par exemple, au nombre de trois. Toutefois, leur nombre est susceptible de varier.

Les deuxièmes portions 155 du conducteur principal 135 sont reliées en série.

Dans le mode de réalisation représenté sur les figures 2 et 3, l'une des deuxièmes portions 155 est électriquement connectée avec la deuxième portion d'extrémité 173. Les autres deuxièmes portions 155 sont reliées en série entre la deuxième portion 155 venue de matière avec la deuxième portion d'extrémité 173 et celle des deuxièmes portions 155 qui est électriquement connectée à l'une des premières portions 150.La deuxième portion d'extrémité 173 relie la deuxième portion 155 correspondante à la deuxième extrémité 125. En particulier, la deuxième portion d'extrémité 173 est électriquement connectée au module de contrôle 85. Toutefois, d'autres configurations sont envisageables.

Chaque premier condensateur 160 présente une capacité supérieure ou égale par exemple à 10 picofarad (pF), notamment comprise entre 10 pF et 4,7 nanofarad (nF).

Chaque premier condensateur 160 est, par exemple, un condensateur de sécurité prévu pour empêcher le passage d'un courant électrique entre la première électrode 175 et la deuxième électrode 180 en cas de défaut électrique du condensateur 160. Plus précisément, le premier condensateur 160 est prévu pour que, en cas de défaut électrique du condensateur 160, notamment causé par une surtension, la première électrode 175 reste distante de la deuxième électrode 180. En d'autres termes, en cas de défaut électrique du condensateur 160, la première électrode 175 ne forme pas un court-circuit avec la deuxième électrode 180.

En particulier, chaque premier condensateur 160 est un condensateur de classe Y prévu pour fonctionner à une tension inférieure à 500 V, notamment comprise entre 150V et 300V, et pour une tension maximale en cas de pic de tension inférieure à 8000 V, notamment inférieure à 5000 V. La classe Y est notamment définie par la norme EN 60384-14.

Le plan de masse 140 est, notamment, tel que, lors de la propagation d'un signal électrique dans la ligne de transmission 90, des lignes de champ qui apparaissent entre le conducteur principal 135 et le plan de masse 140 tendent à diriger des électrons en direction du plan de masse 140.

Le plan de masse 140 est, par exemple, relié à une masse électrique de la ligne de transmission 90. Toutefois, d'autres modes de réalisation sont envisageables, dans lesquels le plan de masse 140 n'est pas relié à une telle masse électrique.

Le plan de masse 140 est porté par le substrat 130. Par exemple, le plan de masse 140 est porté au moins partiellement par une face de support 145 opposée à la face de support 145 portant le conducteur principal 135.

Le plan de masse 140 comporte un ensemble de portions et un ensemble de troisièmes condensateurs 163.

L'ensemble de portions du plan de masse 140 comporte un ensemble de troisièmes portions 152, une quatrième portion 157, une troisième portion d'extrémité 174 et une quatrième portion d'extrémité 176.

Chaque troisième ou quatrième portion 152, 157, ainsi que les troisième et quatrième portions d'extrémité 174, 176, est, par exemple, réalisée sous la forme d'un film conducteur porté par le substrat 130. En particulier, chaque portion 152, 157, 174, 176 est réalisée en un matériau métallique tel que le cuivre.

Les troisièmes portions 152 sont reliées en série. En particulier, aucune quatrième portion 157 n'est interposée entre deux troisièmes portions 152.

Notamment, le plan de masse 140 comporte une troisième partie 167 et une quatrième partie 172, la troisième partie 167 étant délimitée par la première extrémité 120 et par la quatrième partie 172, la quatrième partie 172 étant délimitée par la deuxième extrémité 125 et par la troisième partie 167. Chaque troisième portion 152 est une portion de la troisième partie 167, la quatrième portion 157 étant une portion de la quatrième partie 172.

Chaque troisième portion 152 est, par exemple, une portion d'un niveau de couches externe 147. Selon le mode de réalisation représenté sur la figure 2, chaque troisième portion 152 est portée par la face support 145 opposée à la face support 145 portant les premières portions 150. Toutefois, d'autres modes de réalisation dans lesquels chaque troisième portion 152 est une portion d'un niveau de couches interne 147 sont également envisageables.

L'une des troisièmes portions 152 est électriquement connectée à la troisième portion d'extrémité 174, une autre troisième portion 152 étant électriquement connectée à la quatrième portion 157, les autres troisièmes portions 152 étant reliées en série entre la troisième portion 152 électriquement connectée à la troisième portion d'extrémité 174 et la troisième portion 152 électriquement connectée à l'une des quatrièmes portions 157.

La troisième portion 152 électriquement connectée à la troisième portion d'extrémité 174 est, notamment, venue de matière avec cette troisième portion d'extrémité 174. La troisième portion 152 électriquement connectée à la quatrième portion 157 est, notamment, venue de matière avec cette quatrième portion 157.

Il est défini une largeur pour chaque portion 152, 157, 174, 176. La largeur est mesurée dans un plan perpendiculaire à la direction normale D, selon une direction perpendiculaire à la direction dans laquelle le signal électrique se propage dans la première portion 150.

Selon un mode de réalisation, les troisièmes portions 152 sont alignées selon la direction principale DP, comme représenté sur la figure 3.

Chaque troisième portion 152 est, par exemple, rectangulaire, chaque côté du rectangle étant soit perpendiculaire soit parallèle à la direction principale DP. Dans ce cas, la largeur est mesurée entre les deux côtés parallèles à la direction principale DP.

La largeur de chaque troisième portion 152 est, par exemple, comprise entre 0,5 millimètre (mm) et 50 mm. En particulier, la largeur de chaque troisième portion 152 est supérieure ou égale à la largeur des premières portions 150, notamment supérieure ou égale à 5 fois la largeur des premières portions 150.

Chaque troisième portion 152 est, par exemple, disposée en regard d'une première portion 150 correspondante. En particulier, chaque troisième portion 152 est alignée avec la première portion 150 correspondante selon la direction normale D. Toutefois, d'autres modes de réalisation dans lesquels les troisièmes portions 152 ne sont pas alignées avec les premières portions 150 sont également envisageables.

La quatrième portion 157 est en regard de chaque deuxième portion 155. La quatrième portion 155 présente une largeur supérieure ou égale à 5 fois la largeur des deuxièmes portions 155.

Une distance entre la quatrième portion 157 et les deuxièmes portions 155, mesurée selon la direction normale D est , par exemple, inférieure, notamment strictement inférieure, à une distance selon cette même direction D entre les premières portions 150 et les troisièmes portions 152.

La quatrième portion 157 est, notamment, une portion d'une couche interne 147. En particulier, la quatrième portion 157 appartient au niveau de couche métallique 147 le plus proche du niveau de couche 147 auquel les deuxièmes portions 155 appartiennent. Toutefois, des modes de réalisation dans lesquels les quatrièmes portions 157 sont des portions d'une couche externe 147 sont également envisageables.

La quatrième portion 157 est interposée entre celle des troisièmes portions 152 qui est électriquement connectée à la quatrième portion 157 et la quatrième portion d'extrémité 176.

La quatrième portion 157 est, par exemple, électriquement connectée à la troisième portion 152 correspondante par une via 148 traversant partiellement le support 130 selon la direction normale D.

La quatrième portion 157 est électriquement connectée, notamment venue de matière avec, la quatrième portion d'extrémité 176.

La troisième portion d'extrémité 174 relie la troisième portion 152 correspondante à la première extrémité 120. Par exemple, la première troisième portion d'extrémité 174 est électriquement connectée au connecteur 95.

La troisième portion d'extrémité 174 présente une largeur supérieure ou égale à 5 fois la largeur de la première portion d'extrémité 171.

La troisième portion d'extrémité 174 est, par exemple, une portion d'une couche interne 147. En particulier, la troisième portion d'extrémité 174 appartient au niveau de couches métalliques 147 le plus proche du niveau de couches métalliques 147 portant la première portion d'extrémité 171.

La troisième portion d'extrémité 174 est, par exemple, électriquement connectée à la troisième portion 152 correspondante par une via 148 traversant partiellement le support 130 selon la direction normale D.

La quatrième portion d'extrémité 176 relie la quatrième portion 157 à la deuxième extrémité 125. La quatrième portion d'extrémité 176 est, par exemple, électriquement connectée au module de contrôle 85.

La quatrième portion d'extrémité 176 est en regard de la deuxième portion d'extrémité 173.

La quatrième portion d'extrémité 176 est, par exemple, une portion d'une couche interne 147. En particulier, la quatrième portion d'extrémité 176 appartient au niveau de couches métalliques 147 le plus proche du niveau 147 portant la deuxième portion d'extrémité 173.

Un troisième condensateur 163 est interposé entre chaque paire de troisièmes portions 152 contigües. Par exemple, chaque troisième condensateur 163 comporte une troisième électrode 177 et une quatrième électrode 182, la troisième électrode 177 étant électriquement connectée à une troisième portion 152 et la quatrième électrode 182 étant connectée à une autre troisième portion 152, cette autre première portion 150 étant notamment elle-même connectée à la troisième électrode 177 d'un autre troisième condensateur 163 dont la quatrième électrode 182 est connectée à encore une autre troisième portion 152. Ainsi, les troisièmes portions 152 de chaque paire de troisièmes portions 152 contigües sont reliées en série par un troisième condensateur 163 interposé entre les deux troisièmes portions 152 considérées.

Selon l'exemple représenté sur les figures 3 et 4, le plan de masse 140 comporte quatre troisièmes portions 152 et trois troisièmes condensateurs 163. Toutefois, il est à noter que le nombre de troisièmes portions 152 et de troisièmes condensateurs 163 est susceptible de varier.

Chaque troisième condensateur 163 présente une capacité supérieure ou égale par exemple à 10 pF, notamment comprise entre 10 pF et 4,7 nF.

Chaque troisième condensateur 163 est, par exemple, un condensateur de sécurité prévu pour empêcher le passage d'un courant électrique entre la troisième électrode 177 et la quatrième électrode 182 en cas de défaut électrique du condensateur 163. Plus précisément, le troisième condensateur 163 est prévu pour que, en cas de défaut électrique du troisième condensateur 163, notamment causé par une surtension, la troisième électrode 177 reste distante de la quatrième électrode 182. En d'autres termes, en cas de défaut électrique du condensateur 163, la première électrode 177 ne forme pas un court-circuit avec la deuxième électrode 182.

En particulier, chaque troisième condensateur 163 est un condensateur de classe Y.

Chaque troisième condensateur 163 est, par exemple, porté par une face de support 145 du substrat. En particulier, chaque premier condensateur 160 du conducteur principal 135 est porté par l'une des faces de support 145 tandis que chaque troisième condensateur 163 du plan de masse 140 est porté par l'autre face de support 145.

Selon un mode de réalisation, chaque premier condensateur 160 porté par l'une des faces de support 145 est aligné selon la direction normale D avec un troisième condensateur 163 porté par l'autre face de support 145, comme représenté sur la figure 3. Il est à noter que des modes de réalisation dans lesquels les premiers condensateurs 160 portés par les deux faces de support 145 ne sont pas alignés deux à deux avec les troisièmes condensateurs 163 selon la direction normale D sont également envisageables.

Chaque deuxième condensateur 162 est interposé entre deux deuxièmes portions 155. En particulier, chaque deuxième condensateur 162 comporte deux électrodes reliées chacune à l'une des deux deuxièmes portions 155 entre lesquelles le deuxième condensateur 162 est interposé.

Selon le mode de réalisation représenté sur les figures 3 et 4, le conducteur principal 135 comporte trois deuxièmes portions 155 et deux deuxièmes condensateurs 162. Toutefois, le nombre de deuxièmes portions 155 et de deuxièmes condensateurs 162 est susceptible de varier.

Une capacité est définie pour chaque deuxième condensateur 162. La capacité de chaque deuxième condensateur 162 est inférieure ou égale à 50 picofarads (pF), par exemple comprise entre 1 pF et 20 pF.

Chaque circuit écrêteur de tension 142 est interposé entre le conducteur principal 135 et le plan de masse 140. En particulier, chaque circuit écrêteur de tension 142 comporte une borne de connexion 185 électriquement connectée au conducteur principal 135 et une borne de connexion 190 électriquement connectée au plan de masse 140.

Chaque circuit écrêteur de tension 142 est, notamment électriquement connecté à une deuxième portion 155 du conducteur principal 135 et à la quatrième portion 157 du plan de masse 140.

Chaque circuit écrêteur de tension 142 est configuré pour limiter une différence de potentiel électrique entre le conducteur principal 135 et le plan de masse 140, notamment entre la deuxième portion 155 et la quatrième portion 157 auxquelles le circuit écrêteur de tension 142 est électriquement connecté.

En particulier, chaque circuit écrêteur de tension 142 est propre à empêcher une différence de potentiel électrique entre le conducteur principal 135 et le plan de masse 140 de dépasser une valeur prédéterminée. La valeur prédéterminée est, par exemple, de 30 kV de décharge dans l'air et 25kV de décharge en contact selon la norme IEC61000-4-2.

Des circuits écrêteurs de tension 142 de types différents sont susceptibles d'être utilisés pour limiter la tension électrique entre le conducteur principal 135 et le plan de masse 140.

Chaque circuit écrêteur de tension 142 comprend, par exemple, une ou plusieurs diodes reliant le conducteur principal 135 et le plan de masse 142. Chaque diode présente, en particulier, une faible capacité, par exemple inférieure ou égale à 1 pF, notamment comprise entre 0,1 pF et 0,5pF.

Selon l'exemple de la figure 4, chaque deuxième condensateur 162 est associé à un circuit écrêteur de tension 142 électriquement connecté à l'une des deuxièmes portions 155 auxquelles le deuxième condensateur 162 est relié. En particulier, au moins un deuxième condensateur 162 est interposé entre deux deuxièmes portions 155 électriquement connectées chacune à un circuit écrêteur de tension 142 correspondant.

Le connecteur 95 traverse une paroi du boîtier 75. Le connecteur 95 est configuré pour permettre la transmission d'un signal électrique radiofréquence entre l'intérieur du boîtier 75 et l'extérieur du boîtier 75, notamment entre la ligne de transmission radiofréquence 90 et la première antenne 100.

Le connecteur 95 est susceptible d'être choisi parmi un grand nombre de connecteurs 95. Selon un mode de réalisation, le connecteur 90 est un connecteur coaxial comprenant un conducteur central entouré par un conducteur cylindrique, le conducteur central étant connecté au conducteur principal 135, notamment à la première portion d'extrémité 171 et le conducteur cylindrique étant relié au plan de masse 140, notamment à la troisième portion d'extrémité 174.

Les connecteurs SMA (de l'Anglais « SubMiniature version A ») sont un exemple de connecteurs 95 envisageables.

Le câble 97 est configuré pour transmettre le signal électrique entre le connecteur 95 et la première antenne 100. Le câble 97 est, par exemple, un câble coaxial, mais d'autres types de câbles 97 sont susceptibles d'être envisagés.

La première antenne 100 est reliée au module de contrôle 85 via au moins la ligne de transmission 90. En particulier, la première antenne 100 est reliée au module de contrôle 85 via la ligne de transmission 90, le connecteur 95 et, si un tel câble 97 est présent, via le câble 97.

La première antenne 100 est disposée à l'extérieur du boîtier 75. En particulier, la première antenne 100 est disposée à l'extérieur de l'enceinte 30, notamment fixée sur une face externe de l'enceinte 30.

La première antenne 100 est propre à convertir le signal électrique radiofréquence en une onde électromagnétique radiofréquence et vice-versa. En particulier, la première antenne 100 est propre à générer le message radiofréquence à partir du signal électrique généré par le module de contrôle 85 et transmis à la première antenne 100 à travers la ligne de transmission 90, le connecteur 95 et, optionnellement, le câble 97.

La première antenne 100 est, par exemple, électriquement connectée au câble 97. Cependant, si aucun câble 97 n'est présent, la première antenne 100 est alors connectée directement au connecteur 95.

La première antenne 100 est susceptible d'être choisie parmi un grand nombre de types d'antennes 100 distincts.

Le dispositif de centralisation 55 est, par exemple, propre à recevoir les données générées par le dispositif radiofréquence 50 par communication radiofréquence.

Le dispositif de centralisation 55 est, par exemple, propre à afficher les données en partie ou en totalité sur une interface homme-machine telle qu'un écran, à destination d'un opérateur.

En variante, le dispositif de centralisation 55 est configuré pour transmettre les données par communication radiofréquence au dispositif radiofréquence 50.

Grâce aux premiers condensateurs 160, la première extrémité 120 et la deuxième extrémité 125 sont efficacement isolées l'une de l'autre de manière à éviter le risque d'électrisation d'un opérateur qui toucherait la première antenne 100 ou la partie exposée du connecteur 90, tout en permettant la transmission de signaux électriques radiofréquences entre les deux extrémités de la ligne de transmission 90.

En particulier, les premiers condensateurs 160, de par leur capacité élevée, se comportent comme des conducteurs électriques aux fréquences radio, mais empêchent une tension présentant une faible fréquence, notamment une fréquence inférieure ou égale à 10 kHz, en particulier une tension continue de se propager entre les deux extrémités 120, 125 de la ligne de transmission 90.

Cette ligne de transmission 90 permet notamment d'isoler le connecteur 95 contre les surtensions du réseau d'alimentation électrique fournissant le premier courant à l'alimentation 85.

En outre, il est aisé d'adapter le niveau d'isolation souhaité en modifiant le nombre de premiers condensateurs 160, notamment en fonction de la tension électrique U2 avec laquelle l'alimentation 80 est alimentée.

Un dispositif 50 équipé de cette ligne de transmission 90 est susceptible de comporter une alimentation électrique 80 non-isolée, puisque c'est la ligne de transmission 90 qui permet l'isolation des parties externes du dispositif 50. Il est alors possible d'utiliser pour la partie du dispositif 50 située en amont de la ligne de transmission des composants, et notamment une alimentation électrique 80, de plus petites dimensions que les composants utilisés dans l'état de la technique.

La présence des deuxièmes condensateurs 162 permet d'éviter que des réflexions du signal électrique causées par la propagation du signal électrique dans le câble 97 ne causent des interférences haute tension dommageables pour la qualité du signal électrique, en coupant les signaux à basse fréquence.

Il est à noter que, lorsque le dispositif radiofréquence 50 ne comporte pas de câble 97, la deuxième partie 170 est susceptible d'être absente.

Les circuits écrêteurs de tension 142 permettent d'avoir une protection contre les décharges électrostatiques, les transitoires rapides et la foudre.

Lorsque les premiers condensateurs 160 portés par les deux faces de supports 145 sont alignés deux à deux selon la direction normale D, la ligne de transmission 90 obtenue est particulièrement compacte.

La séparation des premières portions 150 et des deuxièmes portions 155 en deux parties distinctes 170 et 175 des conducteurs 135, 140 permet d'éviter que de trop nombreuses ruptures d'impédance d'une portion à l'autre ne causent des pertes excessives lors de la transmission du signal dans la ligne de transmission 90.

Sur la figure 4, un mode de réalisation spécifique du système de contrôle 15 est représenté à titre d'illustration.

Le système de contrôle 15 comprend au moins un capteur 45, par exemple un ensemble de capteurs 45. Il est à noter que le nombre de capteurs 45 est susceptible de varier.

Chaque capteur 45 est propre à mesurer une valeur d'une grandeur associée au volume intérieur Vi de l'enceinte 20.

Par exemple, le capteur 45 est propre à mesurer une valeur représentative d'un courant électrique circulant dans un conducteur électrique de l'installation 10, le conducteur étant reçu au moins partiellement dans le volume intérieur Vi de l'enceinte 20. La valeur est, par exemple, une valeur d'une tension ou d'une intensité du courant électrique.

En variante, le capteur 45 est propre à mesurer une valeur d'une grandeur thermodynamique du volume intérieur Vi. Par exemple, le capteur 45 est propre à mesurer des valeurs de température, ou encore des valeurs d'un taux d'humidité dans le volume intérieur Vi.

Selon une variante, au moins un capteur 45 est configuré pour mesurer une valeur d'un paramètre d'un organe fonctionnel de l'installation 10.

Il est à noter que d'autres types de capteurs 45 configurés pour mesurer des valeurs d'autres paramètres que ceux détaillés précédemment sont également envisageables.

Chaque capteur 45 est configuré pour délivrer au dispositif radiofréquence 50 les valeurs mesurées. En particulier, chaque capteur 45 est configuré pour générer un message de mesure contenant les valeurs mesurées et pour transmettre le message de mesure au dispositif radiofréquence 50.

Par exemple, le capteur 45 est propre à transmettre les valeurs mesurées au dispositif radiofréquence 50 par communication radiofréquence. Selon un mode de réalisation, le capteur 45 est configuré pour transmettre les valeurs mesurées au dispositif radiofréquence 50 par un protocole de type ZigBee ou WiFi sur une bande de fréquence proche de 2450MHz.

En variante, le capteur 45 est propre à communiquer avec le dispositif radiofréquence 50 par liaison filaire. De préférence, le capteur 45 est alors isolé électriquement, par exemple galvaniquement, du dispositif radiofréquence 50. En complément facultatif, lorsque le capteur 45 est configuré pour mesurer des valeurs de paramètres d'un organe alimenté électriquement de l'installation 10, le capteur 45 est isolé galvaniquement de cet organe.

Le dispositif radiofréquence 50 est, par exemple, configuré pour recevoir les valeurs mesurées des capteurs 45 et pour transmettre les valeurs mesurées au dispositif de centralisation 55 par communication radiofréquence. Dans ce cas, le dispositif radiofréquence 50 joue le rôle de passerelle ou de concentrateur entre les capteurs 45 et le dispositif de centralisation 55.

En particulier, le module de contrôle 85 est, par exemple, configuré pour recevoir les valeurs mesurées par les capteurs 45 et pour générer un message radiofréquence comprenant les valeurs mesurées à destination du dispositif de centralisation 55.

Selon un mode de réalisation particulier, le module de contrôle 85 est, en outre, configuré pour générer des données d'exploitation à partir des valeurs mesurées et pour insérer les données d'exploitation dans le message radiofréquence.

Le module de contrôle 85 comporte, par exemple, une unité de traitement de données 110, un premier module de communication radiofréquence 115, un deuxième module de communication radiofréquence 117 et une deuxième antenne 118.

L'unité de traitement de données 110 est propre à convertir des données telles que les valeurs mesurées par les capteurs 45 en un message de données comprenant les valeurs mesurées et/ou les données d'exploitation.

Le premier module de communication radiofréquence 115 est configuré pour recevoir le message de données, pour convertir le message de données en un signal électrique radiofréquence propre à être transformé en message radiofréquence par la première antenne 100.

Le deuxième module de communication radiofréquence 117 est configuré pour recevoir les valeurs mesurées par les capteurs 45 via la deuxième antenne 118, et pour transmettre ces valeurs mesurées à l'unité de traitement de données 110.

Chacun des modules de communication radiofréquence 115, 117 et/ou l'unité de traitement de données 110 sont, par exemple, réalisés sous la forme d'un composant logique programmable, d'un circuit intégré dédié, ou encore d'un ensemble d'instructions logicielles formant les modules de communication radiofréquence 115, 117 et/ou l'unité de traitement de données 110 lorsque les instructions logicielles sont exécutées sur un microcontrôleur du module de contrôle 85.

Il est à noter que selon une variante envisageable, au moins un capteur 45 est intégré au dispositif radiofréquence 50, par exemple reçu dans le boîtier 75. Dans ce cas, le capteur 45 est par exemple relié au module de contrôle 85 par une liaison filaire, sans requérir le deuxième module de communication radiofréquence 117 et la deuxième antenne 118.

## Revendications

1. Ligne de transmission radiofréquence (90) présentant une première extrémité (120) et une deuxième extrémité (125), la ligne de transmission (90) étant configurée pour permettre la transmission d'un signal électrique radiofréquence entre la première extrémité (120) et la deuxième extrémité (125), la ligne de transmission (90) comportant un conducteur principal (135) et un plan de masse (140) électriquement connecté à une masse électrique de la ligne de transmission (90),
le conducteur principal (135) comportant un ensemble de portions (150, 155, 171, 173) reliées en série entre la première extrémité (120) et la deuxième extrémité (125) et un ensemble de premiers condensateurs (160), l'ensemble de portions (150, 155, 171, 173) comportant un ensemble de premières portions (150), chaque premier condensateur (160) étant interposé entre deux premières portions (150) contigües, chaque premier condensateur (160) comportant une première électrode (175) électriquement connectée à l'une des premières portions (150) entre lesquelles le premier condensateur (160) est interposé et une deuxième électrode (180) électriquement connectée à l'autre des premières portions (150) entre lesquelles le premier condensateur (160) est interposé,
la ligne de transmission radiofréquence (90) étant **caractérisée en ce que** le plan de masse (140) comporte un ensemble de portions (152, 157, 174, 176) reliées en série entre la première extrémité (120) et la deuxième extrémité (125) et un ensemble de deuxièmes condensateurs (163), l'ensemble de portions (152, 157, 174, 176) comportant un ensemble de deuxièmes portions (152), chaque deuxième condensateur (163) étant interposé entre deux deuxièmes portions (152) contigües, chaque deuxième condensateur (163) comportant une troisième électrode (177) électriquement connectée à l'une des deuxièmes portions (152) entre lesquelles le deuxième condensateur (163) est interposé et une quatrième électrode (182) électriquement connectée à l'autre des deuxièmes portions (152) entre lesquelles le deuxième condensateur (163) est interposé.

2. Ligne de transmission radiofréquence selon la revendication 1, dans laquelle chaque premier condensateur (160) est configuré pour empêcher le passage d'un courant électrique entre la première électrode (175) et la deuxième électrode (180) en cas de défaut électrique du premier condensateur (160) et chaque deuxième condensateur (163) est configuré pour empêcher le passage d'un courant électrique entre la troisième électrode (177) et la quatrième électrode (182) en cas de défaut électrique du deuxième condensateur (163).

3. Ligne de transmission radiofréquence selon la revendication 1 ou 2, dans laquelle chaque premier condensateur (160) et chaque deuxième condensateur (163) présente une capacité supérieure ou égale à 10 picofarads, notamment comprise entre 10 picofarads et 4,7 nanofarads.

4. Ligne de transmission radiofréquence selon la revendication 3, dans laquelle le conducteur principal (135) comprend, en outre, au moins deux troisièmes portions (155) et au moins un troisième condensateur (162) présentant une capacité inférieure ou égale à 50 picofarads, le troisième condensateur (162) étant interposé entre les deux troisièmes portions (155) et comportant une cinquième électrode électriquement connectée à l'une des troisièmes portions (155) et une sixième électrode électriquement connectée à l'autre troisième portion (155).

5. Ligne de transmission radiofréquence selon l'une quelconque des revendications 1 à 4, comportant en outre au moins un circuit écrêteur de tension (142) configuré pour limiter, en valeur absolue, une différence de potentiel électrique entre le conducteur principal (135) et le plan de masse (140).

6. Ligne de transmission radiofréquence selon la revendication 4, prise avec la revendication 5, dans laquelle chaque circuit écrêteur de tension (142) comporte une première borne de connexion (185) électriquement connectée à une deuxième portion (155) du conducteur principal (135) et une deuxième borne de connexion (190) électriquement connectée au plan de masse (140).

7. Ligne de transmission radiofréquence selon l'une quelconque des revendications 1 à 6, comportant un substrat (130) présentant deux faces de support (145) parallèles l'une à l'autre, chaque premier condensateur (160) du conducteur principal (135) étant porté par l'une des faces de support (145), chaque deuxième condensateur (163) du plan de masse (140) étant porté par l'autre face de support (145), chaque face de support (145) étant perpendiculaire à une direction normale (D) du substrat (130), chaque premier condensateur (160) du conducteur principal (135) étant aligné selon la direction normale (D) avec un deuxième condensateur (163) correspondant du plan de masse (140).

8. Dispositif radiofréquence comprenant une ligne de transmission radiofréquence (90) selon l'une quelconque des revendications 1 à 7.

9. Dispositif radiofréquence selon la revendication 8, comportant un module de contrôle (85), une antenne (100) reliée au module de contrôle (85) via la ligne de transmission radiofréquence (90) et une alimentation (80) propre à recevoir une première tension électrique et à convertir la première tension électrique en une deuxième tension électrique d'alimentation du module de contrôle (85), la première tension électrique étant notamment supérieure ou égale à 24 volts.

10. Système de surveillance (15) d'une installation (10) comportant une enceinte (20), le système (15) comportant un dispositif radiofréquence (50) selon la revendication 9 et un dispositif de centralisation (55), l'antenne (100) étant disposée à l'extérieur de l'enceinte (30), le module de contrôle (85) étant accueilli à l'intérieur de l'enceinte (20), la ligne de transmission (90) étant configurée pour transmettre des signaux électriques radiofréquence entre le module de contrôle (85) et l'antenne (100), le module de contrôle (85) étant configuré pour communiquer avec le dispositif de centralisation (55) par communication radiofréquence via l'antenne (100).
